# EUROPÄISCHE PATENTSCHRIFT

(11) **EP 0 902 611 B1**
(45) Veröffentlichungstag und Bekanntmachung des Hinweises auf die Patenterteilung: **09.05.2007**
(21) Anmeldenummer: 98116908.9
(22) Anmeldetag: 08.09.1998
(51) Int. Cl.: H05K 5/00, H05K 7/14, H05K 1/02

(54) **Recyclingfähige Leiterplatte bestehend aus einem Folien- und Trägersystem**
Recyclable circuit board comprising a foil and support system
Panneau à circuit recyclable comprenant un système à une feuille et un support

(30) Priorität: 10.09.1997 DE 19739591
(43) Veröffentlichungstag der Anmeldung: 17.03.1999
(73) Patentinhaber: WÜRTH ELEKTRONIK GmbH & Co. KG, D-74676 Niedernhall (DE)
(72) Erfinder: Hanke, Andre Dipl.-Ing. (FH), 04451 Borsdorf (DE); Röhrs, Günter Prof. Dr.-Ing., 01762 Obercarsdorf (DE)
(74) Vertreter: Patentanwälte Ruff, Wilhelm, Beier, Dauster & Partner

(56) Entgegenhaltungen:
- EP-A- 0 642 166
- EP-A- 0 881 674
- WO-A-92/11654
- WO-A-97/36325
- US-A- 5 416 358

## Beschreibung

Die Erfindung betrifft eine recyclingfähige Leiterplatte, bestehend aus einem Folien- und Trägersystem, durch dessen Anordnung und Verbindung zueinander eine uneingeschränkte Recyclingfähigkeit gegeben ist und bei der darüber hinaus das Recycling im Vergleich mit anderen Recyclingkonzepten mit geringstem technologischen Aufwand durchgeführt werden kann.

Es ist bekannt, dass die derzeitig eingesetzten Leiterplatten und andere konventionelle Verdrahtungsträger nicht dem Recyclinganliegen entsprechend konzipiert und somit wegen des festen stofflichen Verbundes von Isolations- und Metallschichten von Beginn an zum Shreddern, Verbrennen und/oder Deponieren vorgesehen sind. Darüber hinaus sind die meist eingesetzten duroplastischen Kunststoffe nicht wiederverwendbar und müssen wegen der enthaltenen Schadstoffe, zum Beispiel halogenierte Flammschutzmittel, die zur Bildung von hochtoxischen Dioxinen und Furanen führen können, auf speziellen Sonder- bzw. Sicherheitsdeponien gelagert werden. Dieser Sachverhalt steht aber im starken Widerspruch mit den im Gesetz zur Vermeidung, Verwertung und Beseitigung von Abfällen (Kreislaufwirtschafts- und Abfallgesetz) vom 27.09.1994, Bundesgesetzblatt, Jahrgang 1994, Teil I, formulierten Forderungen.

Aktuelle Recyclingkonzepte für Leiterplatten gehen gegenwärtig von einer flexiblen Folie als Träger der Funktion (Schaltungsträger mit Bauelementen) aus, die auf einen starren Träger laminiert ist und bei Bedarf von diesem wieder gelöst werden kann. Grundlage dieses Aufbaukonzeptes ist - im Gegensatz zu der meistens bislang angewendeten Funktionenintegration - die Funktionentrennung, die beispielsweise in CH 01768/95-0 für die Herstellung von modular aufgebauten, mehrschichtigen Verbindungssubstraten oder auch in Kostelnik J., Röhrs G.: Entwicklung einer neuen recyclingfähigen Leiterplatte, Wissenschaftliche Zeitschrift der TU Dresden 44 (1995) Heft 4, S. 22 - 26, beschrieben wird.

Aus der DE 44 12 364 A1 bzw. DE 44 39 239 A1 ist eine Leiterplatte mit einem auf einen recyclingfähigen Schaltungsträger ein- bzw. beidseitig laminierten Foliensystem bekannt. Die Laminierung erfolgt hier mittels Kleber. Bei der DE 44 12 364 A1 steht die einfache Zerlegbarkeit im Vordergrund, die durch sogenannte Sollbruchstellen unterstützt wird. Die DE 44 39 239 A1 behandelt die einfache Durchkontaktierung.

Weiterhin ist eine Leiterplatte bekannt, die aus einem den eigentlichen Schaltungsträger bildenden Foliensystem und einem Trägersystem zusammengesetzt ist. Die beiden Teile sind durch Eingießen eines Harzes, das die Zwischenräume zwischen dem Gehäuse und dem Foliensystem ausfüllt, fest miteinander verbunden (US-A-5416358).

Erfahrungsgemäß ist die Forderung nach einer einfachen Zerleg- und Demontierbarkeit von elektronischen Baugruppen in ihre stofflichen Bestandteile mit sortenreiner Fraktionierung des zu recycelnden Materials und somit optimaler Widerverwert- bzw. auch Wiederverwendbarkeit der eingesetzten Werkstoffe bei einer derartigen stoffschlüssigen Verbindung nicht gegeben. Diese Fügetechnik ist zwar ohne Schwierigkeit schnell und voll mechanisiert herstellbar und erzielt gute Gebrauchswerte, jedoch ist diese Art der Verbindung nach der Nutzungsphase weitaus problematischer als alle anderen. Der stoffschlüssige Verbund von Folien- und Trägersystem stellt eine feste Verbindung dar, die sich im Recyclingfall nur schwierig - meist mit größerem Kraftaufwand verbunden - trennen lässt, wobei der Stoffschluss häufig die Ursache für eine Verletzung bzw. Beschädigung der Fügepartner sowie für eine kaum zu umgehende Beeinträchtigung durch Rückstände und Verunreinigungen ist.

Hat nach dem Gebrauch der Leiterplatte die Trennung in ihre stofflichen Bestandteile Beeinträchtigungen, Verunreinigungen, Verletzungen bzw. Beschädigungen der Fügepartner zur Folge, ist die Wiederverwendbarkeit nicht bzw. nur durch eine aufwendige regenerative Bearbeitung gegeben. Somit gehen bei diesem Lösungskonzept nicht wiederverwendbare, noch mit Rückständen, beispielsweise Klebemittel, behaftete Elemente in den Recyclingprozess ein, so dass eine sortenreine Fraktionierung des zu recycelnden Materials nur begrenzt bzw. mit erhöhtem technologischem Aufwand möglich ist.

Es ist daher Aufgabe der Erfindung, für die Verbindung von Folien- und Trägersystem eine geeignete Fügetechnik in Verbindung mit optimierten Aufbauprinzipien bzw. -lösungen vorzuschlagen, die eine sortenreine Fraktionierung des zu recycelnden Materials ermöglicht, ohne die Fügepartner zu verletzen, zu beschädigen oder zu verunreinigen.

Erfindungsgemäß wird die Aufgabe mit den im Anspruch 1 genannten Merkmalen gelöst. Bevorzugte Ausbildungen und Ausgestaltungen ergeben sich aus den Unteransprüchen.

Die Erfindung geht auf das Grundprinzip der kraft-/form- und formschlüssigen Verbindung zurück, die durch vorteilhafte Merkmale, wie einfache Lös- und Schließbarkeit über viele Zyklen, Vermeiden gesondert erforderlicher Befestigungselemente, durch Fehlen rückstandsbildender Fremdmaterialien, Verletzungs- bzw. Beschädigungsfreiheit der Fügepartner im Demontageprozess sowie hinreichende und beständige Fixierung und Lagesicherung der Fügepartner, gekennzeichnet ist.

Im Gegensatz zu einer reinen stoff- bzw. kraftschlüssigen Verbindung zwischen Folien- und Trägersystem, die durch die mechanische Versteifung der Leiterplatte grundsätzlich eine feste Verbindung herstellt, ist der formschlüssige Verbund zwischen Folien- und Trägersystem grundsätzlich eine lose Verbindung, bei der das Foliensystem durch die Formung des Trägersystems, das als sogenanntes Formschlußelement fungiert, eine dauerhafte Stabilisierung ihrer Lage und Form erfährt.

Der Vorteil der erfindungsgemäßen Lösung besteht nun darin, dass durch eine kraft-/form- bzw. formschlüssige Verbindung von Folien- und Trägersystem eine optimale Wiederverwert- bzw. auch Wiederverwendbarkeit der eingesetzten Werkstoffe gegeben ist, wobei der elementare Aufbau des Formschlusselements, der in die zwei verschiedenen Arbeitsprinzipien Einlegen und Einbetten unterteilt werden kann, das Recycling im Vergleich zu anderen Recyclingkonzepten mit minimalem technologischen Aufwand ermöglicht.

Überdies ist hervorzuheben, dass auf Grund der funktionellen Trennung von Foliensystem - dem eigentlichen Schaltungsträger mit Bauelementen - und dem Trägersystem, welches vorrangig die Aufgabe der Formgebung und Stabilisierung des Schaltungsträgers hat, das Foliensystem durch einen minimalen Materialeinsatz der Bestandteile Leitermaterial, wie Kupfer, Nickel und Gold, sowie Isolationsmaterial, beispielsweise hochwertige Kunststoffe wie Polyimid, gekennzeichnet ist und das Formschlusselement idealerweise aus einem sehr billigen Werkstoff, zum Beispiel Kunststoff (auch Recyclat), Keramik oder Metall, bestehen kann. Ein weiterer Vorteil der auf dem Grundprinzip der kraft-/form- und formschlüssigen Verbindung basierenden erfindungsgemäßen Leiterplatte besteht in der Beibehaltung und sogar Verbesserung der bisherigen nutzbringenden elektrischen, thermischen, mechanischen und geometrischen Eigenschaften der konventionellen Leiterplatten bzw. anderer klassischer Verdrahtungsträger.

Die Erfindung wird nachfolgend an mehreren Ausführungsbeispielen näher veranschaulicht. Die Zeichnungen beinhalten folgende Darstellungen:
- Fig. 1: eine Darstellung des Grundprinzips der kraft-/form- und formschlüssigen Verbindung zwischen Folien- und Trägersystem,
- Fig. 2: eine kraft-/formschlüssige Verbindung zwischen Folien- und Trägersystem mit keramikgefüllten Elastomereinlagen,
- Fig. 3: eine Ausführungsform gemäß Figur 2 mit einem zweiseitig bestückten Foliensystem,
- Fig. 4: eine formschlüssige Verbindung zwischen Folien- und Trägersystem durch den Einsatz von Siliconkautschukvergussmassen,
- Fig. 5: eine kraft-/formschlüssige Verbindung zwischen Folien- und Trägersystem realisiert mittels thermoplastischen Elastomeren,
- Fig. 6: eine formschlüssige Verbindung zwischen Folien- und Trägersystem mit granulierten bzw. pulverisierten Materialien,
- Fig. 7: eine formschlüssige Verbindung zwischen Folien- und Trägersystem durch Hüllschalen mit negativer Oberflächenstruktur zur Foliensystemoberfläche,
- Fig. 8: eine kraft-/formschlüssige Verbindung zwischen Folien- und Trägersystem mit Druckelement.

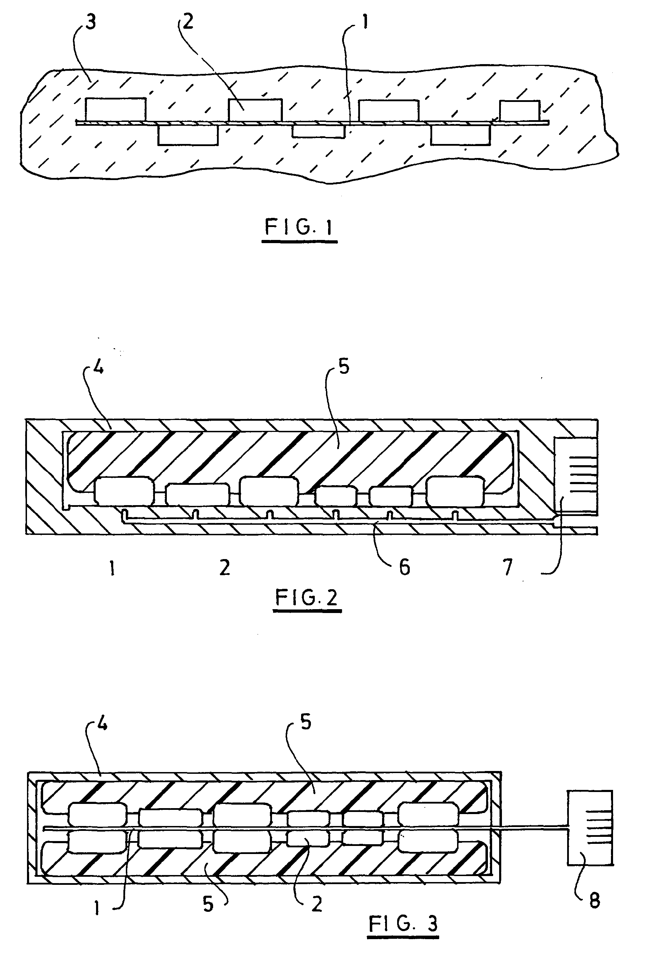

Die Fig. 1 zeigt das Grundprinzip der kraft-/form- und formschlüssigen Verbindung, wobei ein Foliensystem 1 beliebiger Form mit Bauelementen 2 in zwei- und/oder dreidimensionaler Anordnung durch ein beliebig geformtes Formschlusselement 3 gehalten, fixiert und abgestützt wird.

Fig. 2 stellt ein Aufbauprinzip dar, bei dem das Foliensystem 1 durch den Einsatz von keramikgefüllten Elastomereinlagen 5, allgemein bezeichnet als Wärmeleitfolien, eine Stabilisierung der Lage und Form erfährt. Diese viskoelastischen Elastomereinlagen 5 bieten zum einen einen ausgezeichneten Schutz vor dynamischen Einflüssen, beispielsweise Schwingungen, und zum anderen gibt das thermisch gut leitende Siliconelastomer die Verlustleistungsenergie effektiv an die Wandung des Gehäuses 4 weiter. Aber auch Vorteile wie eine homogene Wärmeverteilung über dem ganzen Foliensystem 1 sowie eine gleichmäßige Abstützung und Fixierung der Leiterplattenfolie des Foliensystems 1 auch bei unterschiedlicher Höhe der Bauelemente 2 sind weitere nutzbringende Charakteristika dieses Aufbauprinzips, welches auf der formschlüssigen Fügetechnik basiert.

Allerdings muss das Elastomer der Elastomereinlagen 5 unter einem entsprechenden Druck auf das Foliensystem 1 gepresst werden, um die Oberflächenunebenheiten optimal auszugleichen und geringe Wärmeübergangswiderstände zu realisieren. Es kann eingeschätzt werden, dass die kritischsten Punkte bei der Druckbelastung eines Bauelements die Lötstellen, d.h. genauer die Scherfestigkeit der Lötstellen bei oberflächenmontierten SMD-Bauelementen sind. Das kritischste Bauelement auf dem Foliensystem 1, das für die Beurteilung des Worst-Case-Falls zu bestimmen ist, ergibt sich aus der Betrachtung der Faktoren Größe der Chipfläche, Anzahl der Anschlussdrähte, Formung der Anschlussdrähte sowie der Art und Beschaffenheit des Lotes. Der optimale Anpress- bzw. Kompressionsdruck ist somit von mehreren Faktoren, beispielsweise von den Einsatz-, Leistungs- sowie Konstruktionsbedingungen, abhängig und somit für den jeweiligen Anwendungsfall experimentell zu bestimmen.

Die hohe Durchschlagfestigkeit des Materials garantiert die gewünschten elektrischen Eigenschaften, d.h. ein optimales Isolierverhalten. Durch die Verfügbarkeit beliebiger Abmessungen (kundenspezifischer Zuschnitt) sowie unterschiedlicher Stärken (0,5 mm bis 5,0 mm) sind Elastomereinlagen vielseitig einsetzbar.

Das Gehäuse 4 sollte bei thermisch kritischen Baugruppen vorteilhafterweise aus einem Material mit einer hohen Wärmeleitfähigkeit, z.B. Aluminium, bestehen oder zumindest eine metallische Abdeckung als Gehäuseabschluss besitzen. Aber auch technische Kunststoffe stellen eine interessante Alternative für den Einsatz als Gehäusematerial dar. Die konstruktive Auslegung des Gehäuses 4 erfolgt in Form eines Ober- und Unterteils, wobei beide Teile schalenförmig ausgebildet sind und beispielsweise mittels lösbarer Schnappverbindungen ineinander eingreifen. Auch Gehäusekonstruktionen, die eine dreidimensionale Anordnung des Foliensystems 1 ermöglichen, sind denkbar. Die Integration von optischen Signalleitungen 6 ist ebenfalls vorzusehen. Die Kontaktierung des Foliensystems 1 kann über einen flexibel herausgeführten Steckverbinder oder einen im Gehäuse integrierten Steckverbinder 7 erfolgen.

Die Fig. 3 zeigt eine weitere beispielhafte Ausführungsform des in Fig. 2 veranschaulichten Aufbauprinzips (Beschreibung gemäß Fig. 2), bei dem ein zweiseitig bestücktes Foliensystem 1 durch den Einsatz von Wärmeleitfolien als Elastomereinlage 5 eine auf Formschluss beruhende, hinreichende Lagesicherung und Stabilisierung erfährt. Außerdem ist bei diesem Ausführungsbeispiel die Kontaktierung des Foliensystems 1 über einen flexibel herausgeführten Steckverbinder 8 realisiert.

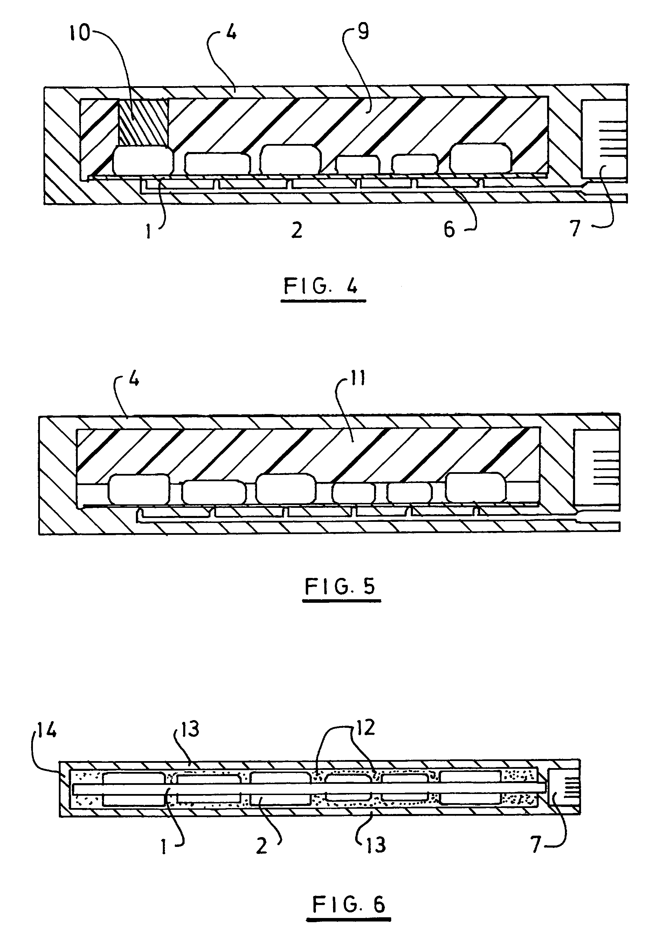

Fig. 4 vergegenständlicht eine Aufbaulösung, bei der die Stabilisierung der Lage und Form sowie die Fixierung des Foliensystems 1 im Raum durch ein Ausgießen mit Siliconkautschuk 9 realisiert wird. Dabei wird die ausgehärtete Siliconkautschukmatte bzw. Isolierfolie durch eine geeignete Struktur des Gehäuses 4, in der auch ein Steckverbinder 7 sowie optische Signalleiter 6 eingelegt werden können, gehalten und kann im Recyclingfall problemlos entnommen werden. Es lässt sich feststellen, dass Siliconkautschuk bereits in der Elektronikindustrie beispielsweise zum Einkapseln von elektronischen Bauteilen erfolgreich eingesetzt wird und somit zu einem unentbehrlichen Hilfsmaterial geworden ist. Besonders additionsvernetzender Siliconkautschuk, der im Gegensatz zu dem kondensationsvernetzenden keine Abspaltprodukte bildet und sich durch eine kurze Vulkanisationszeit auszeichnet, ist für den Einsatz in hermetisch gekapselten Gehäusen geeignet.

Die wichtigsten Kriterien für den Einsatz von Siliconkautschuk in der Elektronik sind:
- die guten elektrischen und dielektrischen Eigenschaften, die geringe Wasseraufnahme, die Flammwidrigkeit sowie dessen Beständigkeit gegen zahlreiche Chemikalien,
- die hervorragende Hitzbeständigkeit der Siliconkautschukvergussmassen bis zu einer Grenztemperatur von 250°C,
- die Dauerelastizität bei Hitze-, Kälte-, Witterungs- und Strahlungsbelastung.

Durch die nichthaftenden Eigenschaften, d.h. die geringe Neigung zum Verkleben, eignet sich Siliconkautschuk außerordentlich gut als Vergussmasse zur Herstellung einer formschlüssigen Verbindung, insbesondere mit dem hier diskutierten Foliensystem 1. Nach dem Aushärten erhält man ein gummielastisches Material, das eine negative Oberflächenstruktur zum Foliensystem 1 besitzt und somit einen bestmöglichen Schutz vor mechanischen Beanspruchungen darstellt.

Durch den direkten allseitigen Kontakt des Siliconkautschuks 9 mit den Bauelementen 2 sind die auftretenden thermischen Übergangswiderstände sehr gering, und es kann somit eine homogene Wärmeverteilung auf dem Foliensystem sowie eine optimale Wärmeableitung an die Wandung des Gehäuses 4 gewährleistet werden, ohne zusätzlich eine Druckbelastung ausüben zu müssen. Durch entsprechende Füllstoffe, die in den Siliconkautschuk eingebracht werden können, lässt sich eine den Elastomereinlagen gleichwertige bzw. bessere Wärmeleitfähigkeit realisieren. Außerdem lässt sich eine wirkungsvolle Kühlung für thermisch kritische Bauelemente lokal vor Ort durch eine zusätzliche Integration einer Wärmesenke 10 erreichen.

Ein weiteres Charakteristikum dieses Aufbauprinzips ist der minimale technologische Aufwand bei der Montage der formschlüssigen Verbindung von Folien- und Trägersystem sowie die Möglichkeit der effizienten und wirtschaftlichen Herstellung der recyclingfähigen Leiterplatte unter der Voraussetzung einer kurzen Aushärtezeit des Siliconkautschuks (Einsatz von Katalysatoren). Überdies ergibt sich der Vorteil, unproblematisch verschiedenartige dreidimensionale Aufbauten zu verwirklichen bis hin zum Eingießen bzw. Eindispensen des Foliensystems in eine Gehäuseform eines elektronischen Gerätes, beispielsweise die Gehäuseschalen eines Funktelefons. Bei der Realisierung von derartigen dreidimensionalen Aufbauten ist der Einsatz von hochviskosen Siliconkautschukvergussmassen, die mittels Dispensertechnik aufgetragen werden, angebracht.

Die Fig. 5 zeigt eine beispielhafte Ausführungsform der formschlüssigen Verbindung von Folien- und Trägersystem, realisiert durch den Einsatz von thermoplastischen Elastomeren (TPE) 11. Bei thermoplastischen Elastomeren 11 handelt es sich um Polymere, welche die Eigenschaften von Elastomeren aufweisen, sich aber wie Thermoplaste verarbeiten lassen. Dabei liefert die harte thermoplastische Komponente die Festigkeit des Materials, hingegen ist die weiche Phase für die Elastizität des Werkstoffes verantwortlich. Die Beschreibung der Fig. 5 entspricht denen der Figuren 2 und 3 mit dem Unterschied, dass die Elastomereinlage durch ein thermoplastisches Elastomer 11 ersetzt wurde. Dies hat den Vorteil, die Schalen des Gehäuses 4 plus angespritzte hochelastische TPE-Schicht 11 in einem Arbeitsgang herzustellen, wodurch auf separate Elastomereinlagen verzichtet werden kann.

Fig. 6 stellt ein Aufbauprinzip dar, bei dem das Foliensystem 1 durch den Einsatz von granulierten bzw. pulverisierten Materialien 12 formschlüssig im Raum gehalten, stabilisiert und allseitig abgestützt wird. Als Füllmaterialien 12 steht ein umfangreiches Potential aus den verschiedensten Grundstoffen der elektrotechnischen und elektronischen Industrie zur Verfügung, deren Auswahl beispielsweise von den Einsatz-, Leistungs- sowie Konstruktionsbedingungen abhängig und somit für den jeweiligen Anwendungsfall zu bestimmen ist. Die zu wählende Krongröße des Granulats bzw. Pulvers 12 ist primär von den mechanischen (Größe der Bauelemente 2, Stabilitätsanforderungen) und thermischen (Verlustleistungsabführung, homogene Wärmeverteilung) Anforderungskriterien der jeweiligen Anwendung abhängig.

Stellvertretend werden hier Keramikgranulat, thermoplastisches Kunststoffgranulat, biologisch abbaubares Kunststoffgranulat, metallisiertes Keramik- oder Kunststoffgranulat, Metallschüttgut - vorzugsweise Aluminiumperlen - etc. genannt. Besonders der Einsatz von preisgünstigen sowie wärmeleitfähigen Keramiken erscheint für dieses Aufbauprinzip lukrativ. Aber auch die Verwendung von abbaubaren und/oder nachwachsenden, aus pflanzlichen Rohstoffen, beispielsweise Jute, Hanf, Flachs, Brennesselfasern, bzw. pflanzlichen Polymeren, wie Stärke, Viskose, Kautschuk und Cellulose, bestehenden Kunststoffgranulaten stellt eine neue zukunfts- und umweltschutzorientierte Alternativlösung dar.

Der Hauptvorteil dieser erfindungsgemäßen Aufbaulösung mit granulierten bzw. pulverisierten Materialien 12 besteht darin, dass einerseits durch eine formschlüssige Verbindung von Folien- und Trägersystem eine optimale Recyclingfähigkeit gegeben ist und andererseits den Anforderungen in punkto elektromagnetische Verträglichkeit (CE-Richtlinien zur EMV) und effektiver Verlustleistungsabführung einfach entsprochen werden kann. Die neue Leiterplatte darf zum einen nicht durch elektromagnetische Strahlung von außen beeinflusst werden und zum anderen auch nicht durch ihren Betrieb eine Emission von elektromagnetischer Strahlung verursachen und damit andere Komponenten in ihrer Wirkungsweise beeinflussen. Durch die Verwendung von Füllstoffen wie Metallschüttgut, vorteilhafterweise Aluminiumperlen oder metallisiertem Keramik- oder Kunststoffgranulat, eventuell noch in Verbindung mit einem Vollmetallgehäuse können diese Forderungen weitestgehend erfüllt werden. Allerdings muss das Foliensystem 1 mit entsprechend geeigneten Isolierlacken vor elektrischen Kurzschlüssen geschützt werden. Die Verlustleistungsenergie lässt sich sehr gut durch keramische oder metallische Füllmaterialien 12 ableiten, wobei Keramik bekanntermaßen auch noch ein guter elektrischer Isolator und ein preiswertes Material ist.

Die Fig. 6 zeigt z.B. einen Querschnitt einer PCMCIA-Karte, die in der Gesamtheit nur 5 mm dick ist und aus zwei Gehäuseabdeckungen 13 mit einer empfohlenen maximalen Dicke von 0,15 mm und einem Gehäuserahmen 14 entweder aus Kunststoff oder Metall aufgebaut ist. Das Foliensystem 1 ist als Multilayer konzipiert, sollte aber nicht mehr als maximal sechs Lagen umfassen, was derzeitig einer technologisch möglichen minimal zu realisierenden Dicke von annähernd 0,5 mm entspricht. Das Foliensystem 1 ist zweiseitig bestückt, wobei sich die maximal zulässige Bauteilhöhe unter der Vorbedingung einer Gesamtdicke von 5 mm aus den restlichen konstruktiven Abmessungen, beispielsweise der Füllhöhe des Granulates, ergibt.

Der Recyclingprozeß gestaltet sich z.B. wie folgt. Nach dem Öffnen der Gehäuseabdeckung wird das Granulat mit einer Absaugvorrichtung entfernt. Das Foliensystem 1 wird mit den Bauelementen 2, d.h. nach Entstückung der wiederverwendbaren sowie der eventuell vorhandenen extrem schadstoffhaltigen Bauelemente und Demontage des Steckverbinders 7, einem Einschmelzvorgang zugeführt, wobei aus der Schmelze die Metalle zurückgewonnen werden. Die Gehäuseteile 13, 14 der Steckverbinder 7 und das Granulat 12 sind wiederverwendbar.

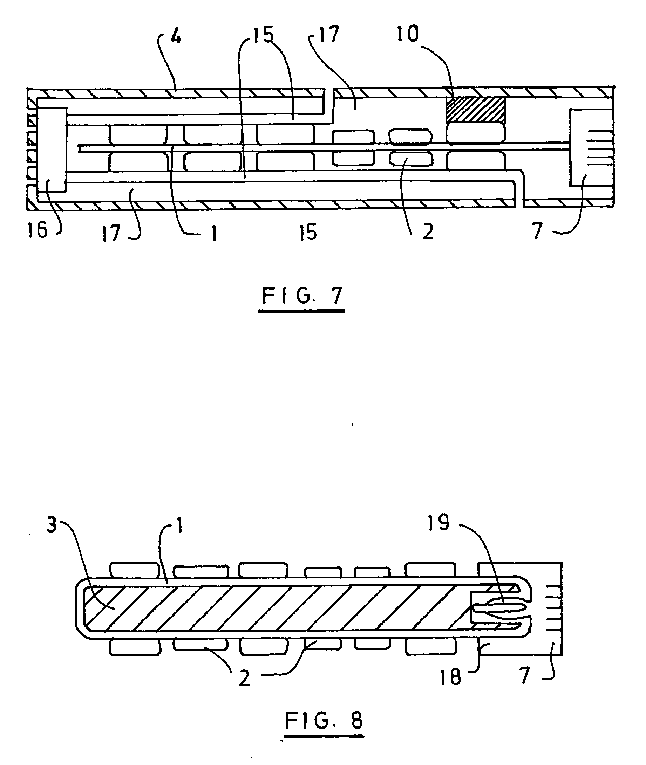

Bei der in Fig. 7 gezeigten Lösungsvariante wird eine flächenhafte Stabilisierung und Lagesicherung des Foliensystems 1 durch Hüllschalen 17, die eine negative Oberflächenstruktur zur Foliensystemoberfläche besitzen, erreicht. Die negative Oberflächenstruktur der zwei Hüllschalen 17 kann mit einem Prägestempel erzeugt werden. Aber auch das Einlegen des Foliensystems 1 in Kunststoff, der sich in einem weichen Zustand befindet, ist denkbar. Der Kunststoff darf sich nach dem Prägevorgang im Abkühlprozess nicht zusammenziehen bzw. verändern, und desweiteren sollte er sich durch eine geringe Wasseraufnahme auszeichnen. Vorstellbar sind Hüllmaterialien wie wasserlösliche Kunststoffe, Polymerschäume und billige Kunststoffe mit entsprechender Glasübergangstemperatur Tg.

Bei der Existenz von thermisch aktiven Bauelementen 2 besteht die Möglichkeit, Wärmesenken 10 in die Hüllschalen 17 zu integrieren oder zusätzliche Strömungskanäle 15 vorzusehen, durch die man unter Verwendung von Druck- und/oder Sauglüftern 16 eine Zwangskonvektion erreichen kann. Die beiden Hüllschalen 17 können beispielsweise mittels lösbaren Schnappverbindungen, die ineinander eingreifen, zusammengefügt werden. Aber auch der Einsatz eines weiteren beispielsweise metallischen Gehäuses 4, in das die Hüllschalen eingepasst werden, stellt eine zweckdienliche Aufbauvariante dar, bei der obendrein sogar noch die Problemschwerpunkte Wärmeabfuhr und EMV-Abschirmung effizient gelöst werden können. Eine Kontaktierung des Foliensystems 1 kann über einen flexibel herausgeführten oder im Gehäuse integrierten Steckverbinder 7 erfolgen. Es sind auch dreidimensionale Gehäusekonstruktionen möglich. Eine interessante Lösung stellt beispielsweise ein Formschlusselement dar, das gleichzeitig als Gehäuse des kompletten elektronischen Gerätes dient, was z.B. bei der Herstellung von Taschenrechnern denkbar wäre.

Fig. 8 stellt ein Aufbauprinzip dar, bei dem eine zweckmäßige Kombination des Form- und Kraftschlusses in den Verbindungselementen erfolgt. Das Foliensystem 1 mit den Bauelementen 2 wird durch den Einsatz eines Druckelementes 18 eingespannt, und zusätzlich erfährt es durch das Vorhandensein eines Trägers bzw. Formschlußelementes 3, d.h. durch deren Umspannung, eine formschlüssige Unterstützung bei der Stabilisierung der Lage und Form. Das Druckelement 18 kann z.B. mit federnden Elementen 19, wie in Fig. 8 gezeigt, oder als Presspassung konzipiert werden. Durch die Einfachheit des Aufbauprinzips kann ein minimaler technologischer Aufwand bei der Herstellung des Formschlusselements (Druckelement mit formschlüssigem Unterteil) sowie bei der Montage der kraft-/formschlüssigen Verbindung von Foliensystem 1 und Trägersystem erreicht werden. Auch dem Trend zur Miniaturisierung, d.h. speziell die Realisierung minimaler Bauhöhen, kommt diese Lösungsvariante entgegen. Überdies ist die Vielfältigkeit an konstruktiven Gestaltungsmöglichkeiten des Formschlusselements 3 bis hin zu verschiedenartigen dreidimensionalen Aufbauten zu nennen.

Das Druckelement 18 und das Formschlusselement 3 sollten aus einem metallischen Material mit einer hohen Wärmeleitfähigkeit, beispielsweise Aluminium, bestehen. Aber auch der Einsatz von preiswerten thermoplastischen Kunststoffen bei der Gewährleistung einer entsprechenden Steifigkeit sowie Wärmeformbeständigkeit ist denkbar. Eine ideale Abführung von Verlustleistungsenergie kann man z.B. durch mit dem Formschlusselement 3, gute Wärmeleitfähigkeit vorausgesetzt, verbundenen Kupferleitbahnen bzw. -flächen erreichen, die ausschließlich zur Wärmeabführung dienen. Aber ebenso sind auch andere, beispielsweise auf Konvektion basierende, Lösungen der Wärmeabfuhr wie eine passive Kühlung durch Kühlkörper (Eigenkonvektion) oder eine aktive Kühlung durch Druck- und/oder Sauglüfter (Zwangskonvektion) auf Grund der offenen Konstruktion unproblematisch realisierbar. Ferner ist durch die gute Zugänglichkeit bei voller Betriebsbereitschaft eine sehr gute Servicefreundlichkeit garantiert. Die Kontaktierung des Foliensystems 1 kann entsprechend den Erfordernissen über einen flexibel herausgeführten oder im Druckelement 18 integrierten Steckverbinder 7 erfolgen.

## Patentansprüche

1. Recyclingfähige Leiterplatte, bestehend aus einem ein- oder beidseitig mit Bauelementen bestückten den eigentlichen Schaltungsträger bildenden Foliensystem (1) und einem der Fixierung und Abstützung des Schaltungsträgers dienenden aus gleich- oder verschiedenartigen Teilen (4, 5, 9, 11, 12, 13, 14, 17, 18, 19) bestehenden im Zusammenspiel als sogenanntes Formschlusselement (3) fungierenden Trägersystem, zwischen denen ein formschlüssiger Verbund besteht, **dadurch gekennzeichnet, dass** der formschlüssige Verbund zwischen Foliensystem (1)und Trägersystem eine lose Verbindung ist, bei der das Foliensystem (1) durch die Formung des Trägersystems (3) eine dauerhafte Stabilisierung seiner Lage und Form erfährt, sowie mit einer der Kontaktierung dienenden Einheit (6, 7, 8).

2. Recyclingfähige Leiterplatte nach Anspruch 1 bei der das Foliensystem (1) durch den Einsatz von elastischen Einlagen, wie keramikgefüllten Elastomereinlagen (5) zwischen den Gehäuseschalen, eine Stabilisierung der Lage und Form erfährt.

3. Recyclingfähige Leiterplatte nach Anspruch 1 oder 2, bei der die Stabilisierung der Lage und Form sowie die Fixierung des Foliensystems (1) durch ein Eindispensen bzw. Eingießen oder Einschäumen mit Vergussmasse oder Vergussschaum, wie mit einer Siliconkautschukvergussmasse (9), in ein den Träger bildendes Gehäuse (4) erfolgt.

4. Recyclingfähige Leiterplatte nach einem der vorhergehenden Ansprüche, bei der die formschlüssige Verbindung von Folien- (1) und Trägersystem durch den Einsatz eines Gehäuses (4) erfolgt, das aus thermoplastischen Elastomeren (11) besteht bzw. zu Teilen mit thermoplastischen Elastomeren (11) eine Verbundhaftung eingeht.

5. Recyclingfähige Leiterplatte nach einem der vorhergehenden Ansprüche bei der das Foliensystem (1) durch den Einsatz von granulierten bzw. pulverisierten Materialien (12), insbesondere durch Keramikgranulat, thermoplastisches Kunststoffgranulat, biologisch abbaubares Kunststoffgranulat, Metallperlen, metallisiertes Keramik- oder Kunststoffgranulat oder andersartig aufgebaute bzw. zusammengesetzte Materialien, formschlüssig in dem vom Trägersystem gebildeten Raum gehalten, stabilisiert und allseitig abgestützt wird.

6. Recyclingfähige Leiterplatte nach einem der vorhergehenden Ansprüche, bei der eine formschlüssige Verbindung und damit eine flächenhafte Stabilisierung und Lagesicherung des Foliensystems (1) durch stützende Elemente, wie Hüllschalen (17), die über eine negative Oberflächenstruktur zur Foliensystemoberfläche oder Teile von dieser verfügen, erreicht wird.

7. Recyclingfähige Leiterplatte nach einem der vorhergehenden Ansprüche, bei der das Foliensystem (1) durch eine Kombination des Form- und Kraftschlusses in den Verbindungselementen, durch den Einsatz eines Druckelementes (18), eingespannt wird und zusätzlich durch das Vorhandensein eines Unterteils bzw. Formschlusselements (3), insbesondere durch deren Umspannung, eine formschlüssige Unterstützung bei der Stabilisierung der Lage und Form erfährt.

8. Recyclingfähige Leiterplatte nach Anspruch 7, bei der das Druckelement (18) mit federnden Klemm-, Stift-, Keil- bzw. Spreizelementen (19) oder als Presspassung konzipiert ist und/oder parallel die Funktion des Steckverbinders übernimmt.

9. Recyclingfähige Leiterplatte nach einem der vorhergehenden Ansprüche, bei der das Trägersystem oder Teile von diesem neben der Stabilisierung der Lage und Form sowie der Fixierung des Foliensystems (1) zusätzlich anderweitige Zusatzfunktionen übernimmt, wie elektrische Isolation, EMV-Abschirmung und Verlustleistungsabführung.

10. Recyclingfähige Leiterplatte nach einem der vorherigen Ansprüche, bei der die den Träger bildende Gehäusestruktur das Gehäuse eines elektronischen Gerätes ist oder Teile von diesem bildet.

## Claims

1. A recyclable circuit board, comprising a foil system (1) equipped with components on one or two sides and forming the actual substrate, and a support system serving to fix and support the sbstrate and comprising similar or different parts (4, 5, 9, 11, 12, 13, 14, 17, 18, 19) and acting in interaction as the so-called form-fit element (3), between which a form-fitting compound arrangement is provided, **characterized in that** the form-fitting compound arrangement between the foil system (1) and the support system is a loose connection whereby the foil system (1) receives permanent stabilization of its position and shape due to the shape of the support system (3) and has a unit (6, 7, 8) serving for the contacting.

2. A recyclable circuit board according to Claim 1, in which the foil system (1) by the use of elastic inserts such as ceramic filled elastomer inserts (5) between the housing shells, experiences stabilisation of position and shape.

3. A recyclable circuit board according to Claim 1 or 2, in which the stabilisation of position and shape and affixing of the foil system (1) occurs through dispensing or filling or foaming with sealing compound or sealing foam, such as a silicone rubber sealing compound (9), in a housing (4) forming the support.

4. A recyclable circuit board according to one of the preceding claims, in which the form-fitting connection of foil (1) and substrate system occurs through the application of a housing (4), consisting of thermoplastic elastomer (11) or partly undergoes composite adhesion with thermoplastic elastomer (11).

5. A recyclable circuit board according to one of the preceding claims, in which the foil system (1) through the application of granulated or powdered materials (12), particularly with ceramic granules, thermoplastic granules, biologically degradable-plastic granules, metal pearls, metal-plated ceramic or plastic granules, different or combined materials are held, stabilised and supported on all sides, in form-closed manner inside the space formed by the substrate system.

6. A recyclable circuit board according to one of the preceding claims, in which a form-fitting connection and thus an areal stabilisation and positional safeguard of the foil system (1) is achieved through supporting elements, like cladding shells (17), which are provided with a surface structure that is negative to the foil system surface or parts of the same.

7. A recyclable circuit board, according to one of the preceding claims, in which the foil system (1) is affixed by a combination of shape and force-fit inside the connection elements, by using a pressure element (18), and additionally through the presence of a lower part or form-fit element (3), particularly by their encapsulation, experiences form-fitting support through the stabilisation of position and shape.

8. A recyclable circuit board according to Claim 7, in which the pressure element (18) is conceived with spring-loaded clamp elements, pin elements, wedge elements or spreading elements (19) or as press fit and/or, in parallel, takes over the function of the plugged connector.

9. A recyclable circuit board according to one of the preceding claims, in which the support system or parts thereof beside the stabilisation of position and shape and affixing the foil systems (1) additionally takes over other additional functions, like electric insulation, EMC shielding and dissipation of power.

10. A recyclable circuit board according to one of the preceding claims, in which the housing structure forming the support is the housing of an electronic device or forms parts thereof.

## Revendications

1. Plaquette à circuit imprimé recyclable comprenant un système de feuilles (1), équipé de composants sur un ou sur deux côtés et formant le support du circuit en soi, et d'un système porteur servant à la fixation et à l'appui du support du circuit, constitué de pièces identiques ou différentes (4, 5, 9, 11, 12, 13, 14, 17, 18, 19) et servant, dans l'interaction, de dit élément d'adhérence par forme (3), entre lesquels il y a une liaison par adhérence de forme, **caractérisée en ce que** la liaison, par adhérence de forme, entre le système de feuilles (1) et le système porteur est une liaison mobile, dans laquelle le système de feuilles (1) obtient une stabilisation durable de sa position et de sa forme en raison du façonnage du système porteur (3) ainsi que par une unité (6, 7, 8) servant au contact.

2. Plaquette à circuit imprimé recyclable selon la revendication 1, dans laquelle le système de feuilles (1) obtient une stabilisation de la position et de la forme en raison de l'utilisation de couches élastiques, comme des couches élastomères (5) remplies de céramique entre les coques de l'enveloppe.

3. Plaquette à circuit imprimé recyclable selon la revendication 1 ou 2, dans laquelle la stabilisation de la position et de la forme ainsi que la fixation du système de feuilles (1) sont réalisées par distribution ou coulage ou moussage d'une masse de remplissage ou d'une mousse de remplissage, comme une masse de remplissage en caoutchouc de silicone (9), dans une enveloppe (4) formant le support.

4. Plaquette à circuit imprimé recyclable selon l'une quelconque des revendications précédentes, dans laquelle la liaison, par adhérence de forme, du système de feuilles (1) et du système porteur est réalisée en utilisant une enveloppe (4) constituée d'élastomères thermoplastiques (11) ou se transforme, pour des pièces avec des élastomères thermoplastiques (11), en une adhérence par liaison.

5. Plaquette à circuit imprimé recyclable selon l'une quelconque des revendications précédentes, dans laquelle le système de feuilles (1) est maintenu, stabilisé et soutenu de tous les côtés par adhérence de forme dans l'espace formé par le système porteur en raison de l'utilisation de matériaux granulés ou pulvérisés (12), notamment de granulés céramiques, de granulés thermoplastiques, de granulés plastiques biodégradables, de perles métalliques, de granulés céramiques ou plastiques métallisés ou de matériaux de structure ou composition différente.

6. Plaquette à circuit imprimé recyclable selon l'une quelconque des revendications précédentes, dans laquelle une liaison par adhérence, et donc une stabilisation plane et un maintien en position du système de feuilles (1), est obtenue au moyen d'éléments de support, comme des coques enveloppantes (17) qui disposent d'une structure de surface négative par rapport à la surface du système de feuilles ou de parties de celle-ci.

7. Plaquette à circuit imprimé recyclable selon l'une quelconque des revendications précédentes, dans laquelle le système de feuilles (1) est encastré en raison d'une combinaison de l'adhérence de forme et de l'adhérence de force dans les éléments composites, en raison de l'utilisation d'un élément de pression (18) et, en outre en raison de la présence d'une partie inférieure ou d'un élément d'adhérence de forme (3), obtient un support par adhérence de forme, lors de la stabilisation de la position et de la forme, notamment en raison de leur blocage.

8. Plaquette à circuit imprimé recyclable selon la revendication 7, dans laquelle l'élément de pression (1) est conçu avec des éléments élastiques de serrage, des éléments à cheville, des éléments de blocage ou des éléments d'écartement (19) ou en tant qu'ajustement par pression et/ou assume la fonction du connecteur.

9. Plaquette à circuit imprimé recyclable selon l'une quelconque des revendications précédentes, dans laquelle le système porteur ou des parties de celui-ci, outre la stabilisation de la position et de la forme ainsi que la fixation du système de feuilles (1), assume en plus d'autres fonctions supplémentaires, telles que l'isolement électrique, le blindage CEM et l'évacuation de la puissance dissipée.

10. Plaquette à circuit imprimé recyclable selon l'une quelconque des revendications précédentes, dans laquelle la structure de l'enveloppe formant le support est le boîtier d'un appareil électronique ou des parties de celui-ci.
